(19) **Europäisches Patentamt / European Patent Office / Office européen des brevets**

(11) **EP 1 838 000 A2**

(12) **EUROPEAN PATENT APPLICATION**

(43) Date of publication:
**26.09.2007 Bulletin 2007/39**

(51) Int Cl.:
***H03M 13/27*** (2006.01)

(21) Application number: **07005817.7**

(22) Date of filing: **21.03.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **21.03.2006 RU 2006108712**

(71) Applicant: **Samsung Electronics Co., Ltd.**
**Suwon-si, Gyeonggi-Do (KR)**

(72) Inventors:
• **Garmanov, Alexander Vasilievich**
**Suwon-si**
**Gyeonggi-do (KR)**

• **Cleveland, Joseph Robert**
**Suwon-si**
**Gyeonggi-do (KR)**
• **Zhdanov, Alexandr Eduardovich**
**Suwon-si**
**Gyeonggi-do (KR)**

(74) Representative: **Grünecker, Kinkeldey, Stockmair & Schwanhäusser**
**Anwaltssozietät**
**Maximilianstrasse 58**
**80538 München (DE)**

(54) **Apparatus and method for transmitting/receiving data in a communication system**

(57) An apparatus and method for transmitting/receiving data in a communication system are provided, in which an information symbol is repeated, the repeated information symbols are interleaved, the interleaved repeated information symbols are organized into groups of a predetermined size, an $n^{th}$ parity check matrix is calculated by modulo summation of an $(n-1)^{th}$ parity check symbol and all interleaved repeated information symbols of an $n^{th}$ group, and a codeword is generated by multiplying each of the information symbols by the parity check matrix and transmitting the codeword.

FIG.3

**EP 1 838 000 A2**

**Description**

**BACKGROUND OF THE INVENTION**

1. Field of the Invention

The present invention generally relates to a communication system. More particularly, the present invention relates to an apparatus and method for transmitting/receiving data in a communication system.

2. Description of the Related Art

In communication systems, data conversion is typically carried out via the following steps:

- Analog-to-digital conversion of a transmission signal;
- Digital signal transmission across wired networks;
- Channel coding;
- Code word transmission on a radio channel;
- Input signal decoding;
- Data signal transmission across wired networks; and
- Digital-to-analog conversion of a digital data sequence.

Analog-to-digital conversion and digital-to-analog conversion are performed by a vocoder called a waveform coder. For an example of the vocoder, see L. R. Rabiner and R. W. Schafer, Digital Processing of Speech Signals, Prentice Hall, Englewood Cliffs New Jersey (1978). At present, vocoders allow signal loss subjectively invisible to a subscriber in data conversion. However, it is expedient to replace empty frames or frames that do not allow digital-to-analog conversion. Therefore, the actual purpose is not only error correction in channel coding but detection of uncorrected errors.

Generally, communication systems employ Cyclic Redundancy Check (CRC) coding to detect errors and convolutional coding to correct errors. In the communication systems, a set of parameters determining Forward Error Correction (FEC) coding and modulation is called a radio configuration. All possible radio configurations are specified in the standard Technical Specification Group-C (TSG-C) (C.S0002-D v1.0, Physical Layer Standard for cdma2000 Spread Spectrum Systems - Revision D). According to this standard, to match the number of transmitted symbols, code symbol puncturing is applied, and, at the same time, each frame contains redundant symbols of a cyclic parity check sum necessary for error detection as a convolutional code decoded by a Viterbi algorithm cannot be used for error detection.

However, in transmitting data, quality of error detection by the cyclic parity check sum is excessive, considering that an error-resilient Enhanced Variable Rate Codec (EVRC) vocoder is used in data transmission. An example of the EVRC vocoder is disclosed in Speech Service Option 3 algorithm for Wideband, Spread Spectrum Digital Systems IS-127 defined by the TIA/EIA/IS-127 Recommendation.

Hence, the channel coding efficiency in data transmission can be enhanced by a code, which would provide both correction and detection of errors and outperforms, in error correction performance, a convolutional code with a constraint length K=9 currently used in communication systems.

A significant requirement is that coder frames are compliant with sizes of data frames generated by the EVRC vocoder. Particularly, the sizes of data frames can be 16, 80, and 172 bits in service option 3 for the EVRC vocoder. See Speech Service Option 3 algorithm for Wideband, Spread Spectrum Digital Systems IS-127 defined by the TIA/EIA/IS-127 Recommendation.

It is well known that a parallel convolutional turbo code approaches a potentially attainable FEC performance. For the parallel convolution turbo code, see Near Shannon Limit Error - Correcting Coding and Decoding, C. Berrou, A. Glaviex, P. Thitimajshina, IEEE International Communications Conference: Proc. 1993-Geneva (Switzerland), pp. 1064-1070. However, the turbo code is not more effective than the convolutional code decoded by the Viterbi algorithm, if the size of a data frame created by the vocoder does not exceed 200 bits.

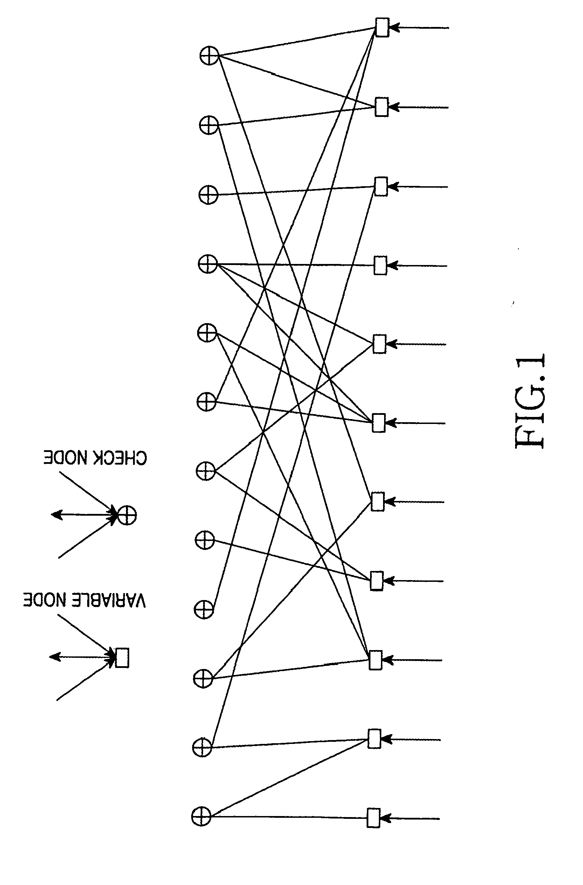

A code sub-class of Low Density Parity Check (LDPC) codes is marked out in the class of linear block codes. For the linear block codes, see Low Density Parity Check Codes. Gallager R., MIT Press 1963. This sub-class outperforms a turbo code. The feature of this code is availability of a simple graphical model of a decoding algorithm defined as decoding on a graph. The graph will be described with reference to FIG 1.

FIG. 1 is a bipartite graph illustrating a general decoding algorithm for an LDPC code.

Referring to FIG. 1, the graph determines division of an entire codeword to shorter codes which can overlap each other. This overlapping can be eliminated by repeating the overlapped code symbols. Different copies of a received code symbol or a soft decision on this symbol fit in different codewords of the shorter code, and all code words of the shorter code could be decoded independently.

Such a structure can be presented in the form of a bipartite graph, one type of nodes of which is associated with code symbols, and the number of edges outgoing from each node complies with the number of code symbol repetitions. A variable node is marked by a rectangle. The other type of nodes corresponds to shorter codes, where each node is a codeword with the number of code symbols equal the number of incoming edges. A parity check node is marked by a circle. Each parity check node can be assigned with a parity check sum as an indicator of errors in the short code. Variable nodes can only be connected with parity check nodes and parity check nodes can be connected with variable nodes.

Such a bipartite graph is called Tanner graph. An example of the Tanner graph is disclosed in A Recursive Approach to Low Complexity Codes, R.M. Tanner, IEEE Transaction on Information Theory., 1981.,Vol. IT-27, № 9. pp. 533-547. Virtually, the Tanner graph is a graphical representation of a parity check matrix for the linear block code. Error-free decoding is characterized by equality of all parity check sums to null.

The closest method to the above method for data transmission in a communication system in a technical feature is described in U.S. Patent No. 4,295,218 to Tanner for Error-correcting coding system, which is a method for decoding on graph involving plotting of the bipartite graph.

In a self-correcting data transmitter, data transmission and reception is performed in the following steps:

(a) establishing a plurality of codewords by

(a1) selecting a connected bipartite undirected graph having a plurality of first nodes and a plurality of second nodes connected together by a plurality of edges; while none of the first nodes are connected to one another and none of said second nodes are connected to one another;
(a2) assigning a digit position for a codeword to each of the first nodes;
(a3) assigning sub-codes to be connected to each of the first nodes;
(a4) assigning a set of values to be associated with selected nodes of the second nodes such that inputs of first nodes connected to the selected second nodes satisfy the code constraints of the sub-codes of the first nodes;
(a5) establishing the set of the values from step (a4) to the digit sequence assigned in step (a2) as an element of the plurality of codewords, and
(a6) repeating steps (a4) and (a5) for different sets of values until the desired number of elements of the plurality of the codewords have not been established;

(b) placing the digits of each codeword as received following transmission in individual storing registers connected as inputs to test nodes corresponding to the first nodes of the graph;
(c) testing the contents of the storing registers as the input depending on constraints of the sub-codes connected to the first nodes;
(d) utilizing the contents of the storing registers as the received codeword, if all code constraints of the sub-codes have been satisfied; otherwise continuing to step (e);
(e) using the contents of the storing registers as the received codeword, if an attempt to perform a pre-selected number of correcting iterations has been made; otherwise continuing to step (f); and
(f) modifying the contents of at least one of the storing registers that is connected as an input to one of the nodes where the code constraint conditions have not been fulfilled, and returning to step (c).

However, it should be noted that the applied code symbol repetition might be generalized, i.e. representation of one of the code symbols in k symbols possibly being of another alphabet.

For example, in the linear block code where a short code means the parity check or additions of all modulo 2 code symbols, the applied short code on a graph will be called the generalized parity check that involves combining all code symbols in the Galois field or adding digits by a specified modulo operation. If there are no errors during transmission, all such check sums shall be equal to zero.

Therefore, operations on the Tanner graph being a graphical model of code division to sub-codes can be described in the form of repetition, interleaving and grouping into groups, and repetition and grouping into group patterns and an interleaving rule unambiguously define a bipartite graph.

Some specific terminology is introduced. A path on the graph is defined as a sequence of vertices where neighboring vertices are adjacent, i.e. connected by the edge in the graph. See, P. J. Cameron, J. H. van Lint "Graph Theory, Coding Theory & Block Designs," M. Nauka 1980. A cycle is a path where an initial vertex and a final vertex coincide. The distance metric between two vertices is assumed to be the length of the shortest path between them. The graph diameter is the highest distance metric between any two graph vertices and the graph girth is the length of the shortest cycle with no repeated edges if such a cycle exists. The vertex valency is the number of edges which touch this vertex or the number of vertices adjacent to this one. If all graph vertices have the same valency, the graph is regular.

The chromatic number of the graph is the least number of colors needed to color all graph edges so that any two edges with a common vertex are colored differently. Hamilton path or Hamiltonian cycle means a closed cycle without repeated edges passing through all graph vertices only once. The graph girth shall not be less than 4.

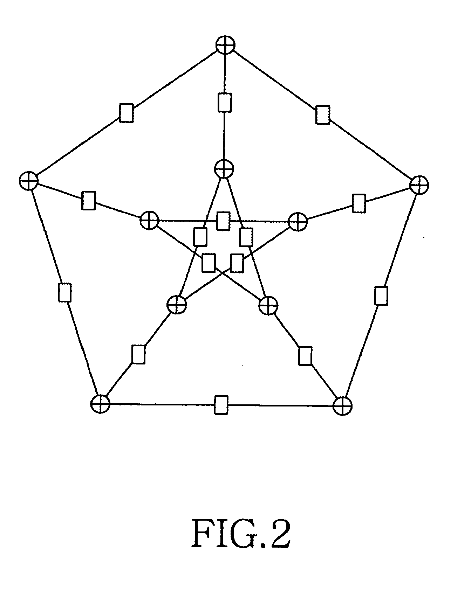

With reference to FIG. 2, a description will be made of a code constructed on a Peterson graph. FIG. 2 illustrates a code constructed on a Peterson graph with a diameter of 6 and a girth of 10. Referring to FIG. 2, the number of vertices is restricted and plotting a graph with more than 100 vertices with preset features is very complex. If the code is systematic and can be separated into parity check and information components, the above described method has a drawback. When a codeword has a decoding error in its parity check part and no errors in its information part, the frame is always marked as erroneous and thus deleted. A CRC parity check sum allows monitoring of errors in the information component of the codeword exclusively.

More specifically, this algorithm can be formulated in terms of message passing, as illustrated in FIG. 1. See, A Recursive Approach to Low Complexity Codes, R.M. Tanner, which discloses as follows.

1. Each variable node is initialized by the a posteriori probabilities of a channel output (soft decision).
2. For each code symbol, calculate a value of the outgoing message of the variable node being equal to a posteriori probability of the reception of a certain value of the code symbol related to this variable node for each edge of the bipartite graph.
3. In each variable node, modify the outgoing messages of the variable nodes to which they are connected by the edge of the bipartite graph and for which they are incoming messages, thus assigning each edge to the outgoing messages of the variable node that are equal to a set of probabilities for the code symbol.
4. Update the outgoing messages of the variable node by the incoming messages being outgoing messages of the parity check node.
5. Repeat a certain number of times or until code constraints are fulfilled.

The sign of the outgoing message is selected to satisfy code constraints. The absolute value of the outgoing message is calculated by means of a function $f$. This decision function is a logarithm of the likelihood ratio (Log-likelihood ratio). The function has the commutative property shown in Equation (1) below:

$$f(a,b,c,d) = f(a, f(b, f(c, f(d))))$$
$$\cdot \ f(d) = d$$

$$\ldots\ldots(1)$$

There are some methods for setting the function $f$. The simplest one is known as a min-sum algorithm. The absolute value of the outgoing message is equal to the minimum absolute value of the considered incoming messages except the message of the node to which this outgoing message is assigned. This is expressed as Equation (2):

$$f\left(\left|Q_{m',n}\right|, except \left|Q_{m',n'}\right|\right) = min_{n \neq n'}\left(\left|Q_{m',n}\right|\right)$$

$$\ldots\ldots(2)$$

Another method of setting the function $f$ is to determine the function by a function $E(x)=log(1-exp(-|x|))$ used in the LOG MAP algorithm disclosed in Implementation and Performance of a Turbo/MAP Decoder, S.S. Pietrobon, International J. of Satellite Communication., 1998. Vol. 16 (Jan-Feb). pp.23-46.

The function is given as Equation (3):

$$f(a,b) = min(a,b) + \delta,$$
$$\delta = log(1 - exp(-|a+b|)) - log(1 - exp(-|a-b|))$$

$$\ldots\ldots(3)$$

The function $E(x) = log(1- exp(-|x|))$ can be represented in the form of a table. A modification can be made to the proposed method, where the additional summand δ is determined as Equation (4):

$$\delta = \begin{cases} 1, |a-b| \le 1, |a+b| > 1 \\ -1, |a-b| > 1, |a+b| \le 1 \\ 0, else \end{cases}$$

$$\ldots\ldots(4)$$

A modification of the algorithm is provided by W. K. Leung, W. L. Lee, A. Wu and L. Ping in Efficient Implementation Technique of LDPC Decoder, Electron. Lett., Vol.37(20), pp.1231-1232, Sept 2001. This method does not require the table, but leads to performance degradation even though it reduces the number of decoding operations.

The efficiency of graphical decoding depends on the availability of graph structures leading to low-weight codewords. These structures have shortcomings. One of the shortcomings is a "stopping set" (see Tom Richardson and Rudiger Urbanke, The Capacity of Low-Density Parity-Check Codes under Message-Passing Decoding, March 9, 2001) and loop or cycle as well (see David MacKay, Good Error-Correcting Codes Based on Very Sparse Matrices, IEEE Transaction on Information Theory, Vol. 45, March 1999). The stopping set is defined as a sub-set of parity check nodes where there are no variable nodes connected with any of the parity check nodes included in this sub-set by a single edge. A set of variable nodes connected to the stopping sub-set contain more probable combinations of errors.

As described above, the graph can be given by setting a repetition and grouping pattern, and an interleaving law. Assuming an ideal interleaving, the optimized repetition and grouping patterns based on regular repetition are obtained (see, Thomas J. Richardson and Rüdiger L Urbanke, Efficient Encoding of Low-Density Parity Check Codes). The actual task is to develop the interleaver separately and to combine it with known optimized repetition-grouping patterns in such a way that the number of the graphical defects can be reduced as soon as possible.

An example of a code allowing message-passing decoding is a repeat accumulate code from a turbo-like code class (see, H. Jin, A. Khandekar and R. J. McEliece, Irregular Repeat-Accumulate Codes, Proceedings of the Second International Symposium on Turbo Codes and Related Topics, pp. 1-8, Brest, France, September 2000). Repeat accumulate codes are encoded in the following way: (a) repetition of each information symbol, (b) interleaving of the repeated symbols, and (c) accumulation of modulo 2 sum of the interleaved symbols.

These codes have the same properties as turbo codes and LDPC codes. Hence, they can be decoded by a message-passing algorithm or a MAP algorithm. The algorithm of the latter case is basically a hybrid algorithm including a MAP algorithm for two-state convolutional code decoding and a message passing algorithm for non-uniform repeated information symbols (see, J. Li, Low-Complexity, Capacity-Approaching Coding Schemes: Design, Analysis and Applications, Ph.D. dissertation, Texas A&M University, 2002). It is known that the highest efficiency is achieved by use of non-uniform or irregular repetition of the information symbols (see, H. Jin, A. Khandekar and R. J. McEliece, Irregular Repeat-Accumulate Codes, Proceedings of the Second International Symposium on Turbo Codes and Related Topics, pp. 1-8, Brest, France, September 2000).

Besides, the performance of the repeat accumulate codes is mainly characterized by the interleaver that, together with the irregular repetition pattern and parity check sum accumulation pattern, determines the Tanner graph for the given code. The interleaver requirements lie in providing sufficient spread of the repeated symbols, thus ensuring absence or a few number of low weight codewords.

There are two classes of interleavers - randomized and deterministic.

A randomized interleaver includes a random number generator for determining the number of the interleaved symbols in a sequence after the interleaver is determined. The sequence of the achieved numbers is subject to checking for spread sufficiency of consecutive information symbols with roll back of sequences, which have not passed this checking. Particularly, the "S-random" algorithm is disclosed in Dolinar and D. Divsalar, Weight Distribution for turbo Codes Using Random and Non-Random Permutation, JPL Progress report 42-122, pp. 56-65, Aug. 15, 1995, in which each new selected random number of symbols to be transmitted is compared with pre-selected numbers $S$ and if the number difference module is less than $S$, a new number is selected. A modified S-random algorithm is provided in U.S. Patent No. 6,453,442 to Sadjadpour, et al.

Randomized interleavers present difficulties due to a memory capacity requirement, computation resources, and a computation latency. In addition, randomized interleavers cannot be generated at the receiver and transmitter sides independently.

Deterministic interleavers do not have such a disadvantage as the method of biunique interleaving mapping is determined by setting a parameterized algorithm. Such interleavers can be formed on fly, i.e. during decoding, and are setup by determining the algorithm parameters (some positive integers). There is a known solution representing a pseudo-random relative prime interleaver claimed in U.S. Patent No. 6,857,087, to Crozier, et al. This method includes interleaving the sequence of K ordered elements formed as m sub-sequences, each having R elements on average, in which:

1. elements within each of the *m* sub-sequences are permuted to form a sequence of *K* elements ordered by a law setup in the pilot sequence, thus forming a pilot pseudo-random sub-sequence.
2. K elements in the pilot pseudo-random sequence of K ordered elements are permuted to form an interleaved sequence produced as n sub-sequence, the sub-sequences having W elements on average.
3. the elements within each of the n sub-sequences are permuted to produce a permuted sequence of K ordered elements.

Step 2 is performed by a relative prime interleaver corresponding to the following transform $i_{new}=(p \times i_{old}+s)$ mod $N$, where N is the number of elements interleaved, $i_{old}$ is an old number in the first interleaved sequence, and p is a relative prime number with N. This interleaver is also called a cyclic shift interleaver (see, S. Dolinar and D. Divsalar, Weight Distribution for Turbo Codes using Random and Non-Random Permutation, JPL Progress Report 42-122, pp. 56-65, August 15, 1995).

However, this method does not guarantee efficiency for a small block size ($\leq$ 200 bits). Therefore, it is obvious that both analyzed solutions do not resolve the problem of interleaver optimization in iterative decoding if the data block size is from 10 to 200 bits as they do not provide sufficient spread of the code symbols.

The above conventional coding and interleaving schemes for data transmission are highly complex or are not optimized in performance. Moreover, with the non-optimized coding and interleaving schemes, efficient error detection and error correction cannot be achieved.

## SUMMARY OF THE INVENTION

An aspect of exemplary embodiments of the present invention is to address at least the problems and/or disadvantages and to provide at least the advantages described below. Accordingly, an aspect of exemplary embodiments of the present invention is to provide an apparatus and method for transmitting/receiving data in a communication system.

Another aspect of exemplary embodiments of the present invention provides an apparatus and method for transmitting/receiving data using a coding scheme with a reduced complexity in a communication system.

A further aspect of exemplary embodiments of the present invention provides an apparatus and method for transmitting/receiving data using an optimized interleaving scheme in a communication system.

Still another aspect of exemplary embodiments of the present invention provides an apparatus and method for transmitting/receiving data using code symbol interleaving in a communication system.

Yet another aspect of exemplary embodiments of the present invention provides an apparatus and method for transmitting/receiving data by reducing repeated data in a communication system.

In accordance with an aspect of exemplary embodiments of the present invention, there is provided a method for transmitting data in a communication system, in which an information symbol is repeated, the repeated information symbols are interleaved, the interleaved repeated information symbols are organized into groups of a predetermined size, an $n^{th}$ parity check matrix is calculated by modulo summation of an $(n-1)^{th}$ parity check symbol and all interleaved repeated information symbols of an $n^{th}$ group, and a codeword is generated by multiplying each of the information symbols by the parity check matrix and transmitting the codeword.

In accordance with another aspect of exemplary embodiments of the present invention, there is provided a method for receiving data in a communication system, in which correlation responses are formed for code symbols of a received codeword, a noise factor of the received codeword is estimated, the code symbols are soft-decided using the noise factor, the soft decisions are divided into soft decisions about information symbols and soft decisions about parity check symbols, the soft decisions about information symbols and the soft decisions about parity check symbols are repeated, the repeated information symbol soft decisions are interleaved, the interleaved information symbol soft decisions are grouped, an $n^{th}$ parity check codeword is formed by updating an $n^{th}$ group of the interleaved information symbol soft decisions with a second copy of the soft decision about an $(n-1)^{th}$ parity check symbol and a first copy of the soft decision about $n^{th}$ parity check symbol, a decoded codeword is created by decoding the interleaved information symbol soft decisions, an ordered sequence of parity check sums is generated by multiplying the decoded codeword by a parity check matrix, the difference between the numbers of the parity check sums in each pair is calculated, all calculated differences are added, the sum of the differences is compared with a predetermined threshold, it is determined that an information part of the codeword is decoded incorrectly, if the sum exceeds the threshold, and it is determined that the information part of the codeword is decoded correctly if the sum is equal to or less than the threshold.

In accordance with a further aspect of exemplary embodiments of the present invention, there is provided an apparatus for transmitting data in a communication system, in which a repeater repeats an information symbol, an interleaver interleaves the repeated information symbols, an organizer organizes the interleaved repeated information symbols into groups of a predetermined size, an adder calculates an $n^{th}$ parity check matrix by modulo summation of an $(n-1)^{th}$ parity check symbol and all interleaved repeated information symbols of an $n^{th}$ group, and a multiplexer generates a codeword by multiplying each of the information symbols by the parity check matrix and transmitting the codeword.

In accordance with still another aspect of exemplary embodiments of the present invention, there is provided an apparatus for receiving data in a communication system, in which a noise factor estimator forms correlation responses for code symbols of a received codeword and estimates a noise factor of the received codeword, a divider for soft-decides the code symbols using the noise factor and dividing the soft decisions into soft decisions about information symbols and soft decisions about parity check symbols, a first repeater repeats the soft decisions about information symbols, a second repeater repeats the soft decisions about parity check symbols; an interleaver interleaves the repeated information symbol soft decisions, a former groups the interleaved information symbol soft decisions and forms an $n^{th}$ parity check codeword by updating an $n^{th}$ group of the interleaved information symbol soft decisions with a second copy of the soft decision about an $(n-1)^{th}$ parity check symbol and a first copy of the soft decision about $n^{th}$ parity check symbol, a decoder creates a decoded codeword by decoding the interleaved information symbol soft decisions, a calculator generates an ordered sequence of parity check sums by multiplying the decoded codeword by a parity check matrix, calculates the difference between the numbers of the parity check sums in each pair, and adds all calculated differences, and a controller compares the sum of the differences with a predetermined threshold, determines that an information part of the codeword is decoded incorrectly, if the sum exceeds the threshold, and determines that the information part of the codeword is decoded correctly if the sum is equal to or less than the threshold.

## BRIEF DESCRIPTION OF THE DRAWINGS

The above and other objects, features and advantages of certain exemplary embodiments of the present invention will be more apparent from the following detailed description taken in conjunction with the accompanying drawings, in which:

FIG 1 is a bipartite graph illustrating a typical decoding algorithm for an LDPC code;
FIG 2 illustrates a code constructed on a Peterson graph;
FIG 3 is a block diagram of a transmitter for data transmission in a communication system according to an exemplary embodiment of the present invention;
FIG 4 is a block diagram of a receiver for data reception in the communication system according to an exemplary embodiment of the present invention;
FIG 5 is a block diagram of a decoder according to an exemplary embodiment of the present invention;
FIG 6 is a flowchart illustrating an error detection algorithm for a codeword according to an exemplary embodiment of the present invention;
FIG 7 illustrates undetected errors according to an exemplary embodiment of the present invention;
FIG 8 illustrates a case where errors occur in the parity check part of a codeword according to an exemplary embodiment of the present invention;
FIG 9 illustrates spreading of non-zero parity check sums with a distance proportional to an interleaver spread factor;
FIG. 10 is a flowchart illustrating an interleaving method according to an exemplary embodiment of the present invention;
FIG 11 illustrates an interleaving graph (Chvatal graph) according to the exemplary embodiment of the present invention;
FIG 12 illustrates an interleaving graph (Gumbaum graph) according to the exemplary embodiment of the present invention;
FIG 13 is a flowchart illustrating an interleaving method according to another exemplary embodiment of the present invention;
FIG 14 illustrates an interleaving graph according to the second exemplary embodiment of the present invention;
FIG 15 illustrates an interleaving graph according to the second exemplary embodiment of the present invention; and
FIG 16 is a graph illustrating performance when data is transmitted and received according to the exemplary embodiment of the present invention.

## DETAILED DESCRIPTION OF PREFERRED EMBODIMENTS

The matters defined in the description such as a detailed construction and elements are provided to assist in a comprehensive understanding of exemplary embodiments of the invention. Accordingly, those of ordinary skill in the art will recognize that various changes and modifications of the embodiments described herein can be made without departing from the scope and spirit of the invention. Also, descriptions of well-known functions and constructions are omitted for clarity and conciseness. Throughout the drawings, the same drawing reference numerals will be understood to refer to the same elements, features and structures.

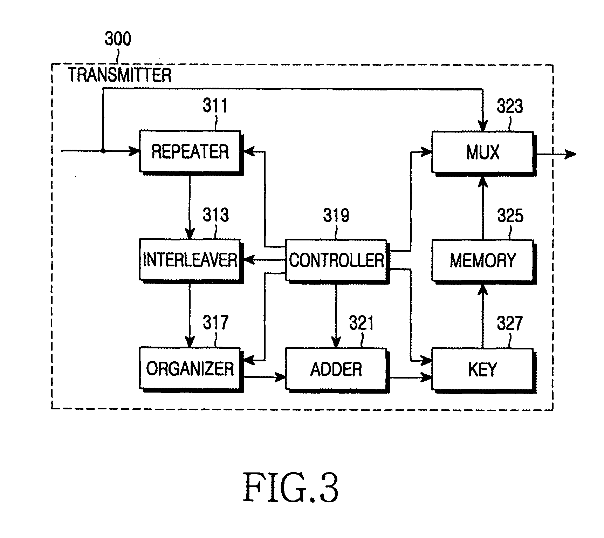

FIG 3 is a block diagram of a transmitter for data transmission in a communication system according to an exemplary embodiment of the present invention.

Referring to FIG 3, a transmitter 300 includes a repeater 311, an interleaver 313, an organizer 317, a controller 319, an adder 321, a Multiplexer (MUX) 323, a memory 325, and a key 327. The controller 319 outputs a control signal for controlling each module in the transmitter 300 and a synchronization signal for the operations of the modules.

A first output of the controller 319 is connected to a second input of the repeater 311, a second output of the controller 319 is connected to a second input of the interleaver 313, a third output of the controller 319 is connected with a second input of the organizer 317, a fourth output of the controller 319 is connected to a second input of the adder 321, a fifth output of the controller 319 is connected to a second input of the key 327, and a sixth output of the controller 319 is connected to a second input of the MUX 323.

A first input of the repeater 311 is information symbols of a data frame. The information symbols are also provided to the MUX 323. The repeater 311 repeats the information symbols a predetermined number of times.

The interleaver 313 interleaves the repeated information symbols such to sufficiently spread the symbols. The organizer 317 groups the interleaved symbols. The adder 321 obtains a first check symbol, for example, a first parity check symbol by preset modulo addition of a predetermined initial value and the interleaved symbols of a first group. In the same manner, the adder 321 obtains an $n^{th}$ parity check symbol by modulo addition of an $(n-1)^{th}$ parity check symbol and the interleaved symbols of an $n^{th}$ group. That is, the adder 321 calculates a parity check matrix by modulo addition of a previous parity check matrix and the interleaved symbols of a current group.

The key 327 provides the parity check symbols received from the adder 321 in the memory 325. The memory 325 stores the received parity check symbols and provides them to the MUX 323 so that the parity check symbols can be added to the information symbols. When the adder 321 generates a current parity check symbol, the memory 325 provides a previous parity check symbol to the adder 321. The MUX 323 adds the parity check symbols to the information symbols, thus creating a codeword, and sends the codeword on a communication channel to a receiver.

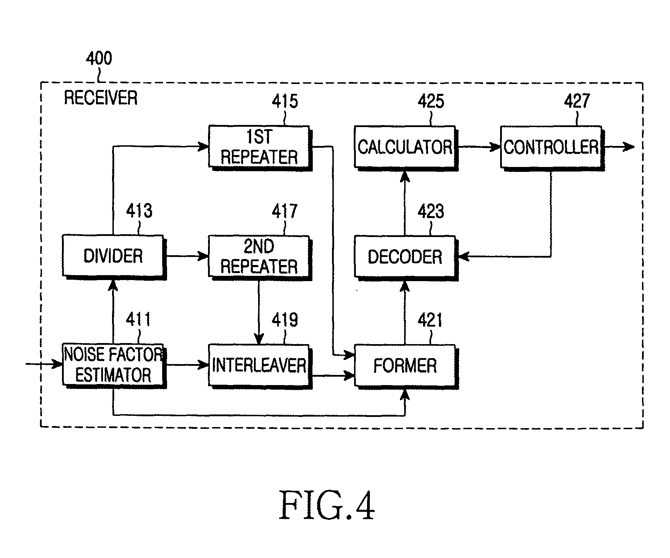

FIG 4 is a block diagram of a receiver for data reception in the communication system according to an exemplary embodiment of the present invention. Referring to FIG 4, a receiver 400 includes a noise factor estimator 411, a divider 413, a first repeater 415, a second repeater 417, an interleaver 419, a former 421, a decoder 423, a calculator 425, and a controller 427.

A signal received at the receiver 400 on the communication channel is provided to the noise factor estimator 411. A first output of the noise factor estimator 411 is connected to the input of the divider 413 and a second output of the noise factor estimator 411 is connected to a first input of the former 421.

A first output of the divider 413 is connected to the input of the second repeater 417 whose output is connected to a second input of the former 421 through the interleaver 419.

A second output of the divider 413 is connected to the input of the first repeater 415, whose output is connected to a third input of the former 421.

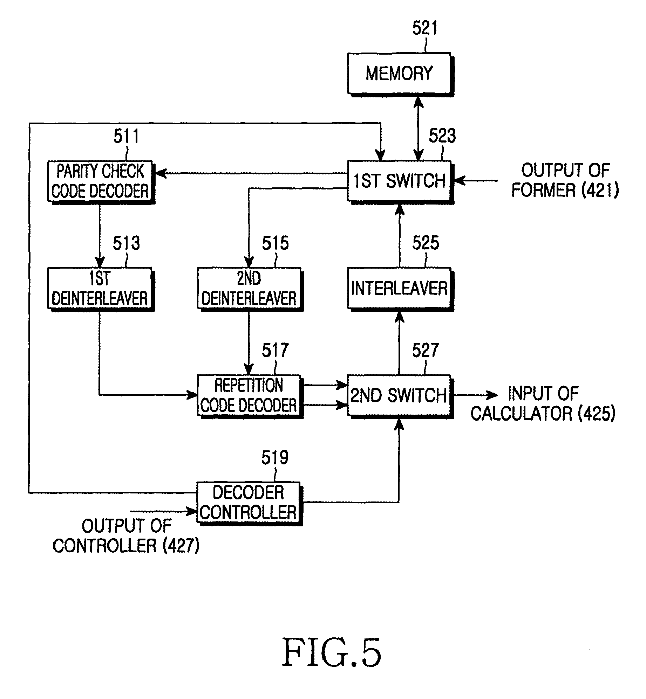

' The output of the former 421 is connected to a first input of the decoder 423. The structure of the decoder 423 will be described later in detail with reference to FIG. 5.

The output of the decoder 423 is connected to the input of the calculator 425, whose output is connected to the input of the controller 427.

A first output of the controller 427 is connected to a second input of the decoder 423 and a second output of the controller 427 is an output of the receiver 400.

The receiver 400 receives a codeword from the transmitter.

In operation, the noise factor estimator 411 forms correlation responses for the code symbols of the received codeword and estimates a noise factor of the received signal, i.e. a signal and noise mixture. The noise factor is approximately equal to the standard deviation of an equivalent Gaussian noise that approximates channel interference. That is, the noise factor estimator 411 estimates the noise under the assumption of a White Gaussian noise channel environment.

The divider 413 soft-decides the received code symbols using the noise factor. The soft decisions include soft decisions about information symbols and soft decisions about parity check symbols. Hence, the divider 413 organizes the soft decision on the received code symbols into the information symbol soft decisions and the parity check symbol soft decisions.

The second repeater 417 repeats the soft decisions about information symbols received from the divider 413 according to an information symbol repetition pattern. Hence, the second repeater 417 can be an information symbol repeater. The repeated information symbol soft decisions are provided to the first interleaver 419.

The first repeater 415 repeats the soft decisions about parity check symbols received from the divider 413 at least twice, except for the last parity check symbol. Hence, the first repeater 415 can be a parity check symbol repeater.

The repeated parity check symbol soft decisions are provided to the former 421.

The interleaver 419 interleaves the repeated information symbol soft decisions, for example, in an interleaving method similar to that at the transmitter.

The former 421 groups the interleaved information symbol soft decisions received from the first interleaver 419 into groups similar to the respective information symbol groups of the transmitter using the signals received from the first repeater 415 and the noise factor estimator 411.

The former 421 updates a first group of the interleaved information symbol soft decisions with a soft decision corresponding to an initial value of an adding variable and a first copy of the soft decision about the first parity check symbol, thus forming a first codeword of the parity check code. Then the former 421 updates an $n^{th}$ group of the interleaved information symbol soft decisions with a second copy of an $(n-1)^{th}$ parity check symbol and a first copy of the soft decision about an $n^{th}$ parity check symbol, thus forming an $n^{th}$ codeword of the parity check code. Here, the updating may amount to addition.

The signals used in the noise factor estimator 411 and the first repeater 415 are formed with respect to the soft decisions calculated in the divider 413 to be similar to the respective groups of signals used in the transmitter.

The decoder 423 decodes according to the present invention. It decodes the signal received from the former 421 and provides the resulting decoded codeword to the calculator 425. The decoder 423 receives an outgoing message of the interleaver 419 through the former 421 and decodes the message, thereby creating a decoded codeword. The operation of the decoder 423 will be detailed later.

The calculator 425 obtains an ordered sequence of parity check sums by multiplying the decoded codeword by a parity check matrix. If all parity check sums are equal to zero, it is determined that the codeword is decoded correctly. If the number of non-zero parity check sums is odd and the last parity check sum is non-zero, the last parity check sum is replaced with zero. If the number of non-zero parity check sums is even and the last parity check sum of the sequence equals zero, it is replaced with any non-zero value.

The sequence of parity check sums is organized into pairs, each including successive elements, and each parity check sum is included in an individual pair.

The calculator 425 calculates the difference between the numbers of the parity check sums in each pair, adds all calculated differences, and outputs the sum to the controller 427.

The controller 427 controls errors of the decoded codeword. It compares the obtained value (i.e. the sum of the differences between the numbers of parity check sums) received from the calculator 425 with a predetermined threshold. If the value exceeds the threshold, the controller 427 determines that an information part of the codeword is decoded incorrectly. If the obtained value is equal to or less than the threshold, the controller 427 determines that the information part of the codeword is decoded correctly.

FIG 5 is a block diagram of the decoder 423 according to an exemplary embodiment of the present invention.Referring to FIG 5, the decoder a parity check code decoder 511, a first deinterleaver 513, second deinterleaver 515, a repetition code decoder 517, a decoder controller 519, a memory 521, a first switch 523, an interleaver 525 and a second switch 527.A first input of the first switch 523 is connected to the former 421 illustrated in FIG 4 and a second input of the first switch 523 is connected to a first output of the decoder controller 519.

The input of the decoder controller 519 is connected to a first output of the controller 427 illustrated in FIG 4.A third input of the first switch 523 is connected to the input/output of the memory 521. A first output of the first switch 523 is connected to the input of the parity check code decoder 511 and the output of the first switch 523 is soft decisions of each codeword of the parity check code.

The output of the parity check code decoder 511 is connected to a first input of the repetition code decoder 517 through the first deinterleaver 513. A second output of the first switch 523 is a soft decision on a code symbol stored in the memory 521 and is connected to a second input of the repetition code decoder 517 through the second deinterleaver 515.

A first output of the repetition code decoder 517 being an outgoing message of a codeword is connected to the input of the interleaver 525 via a first input of the second switch 527. The output of this interleaver 525 is connected to a fourth input of the first switch 523.

A second output of the repetition code decoder 517 being a decoded codeword is connected to a second input of the second switch 527. The output of the second switch 527 is connected to the input of the calculator 425 illustrated in FIG 4. A third input of the second switch 527 is a control input and is connected to a second output of the decoder controller 519.

The first switch 523 switches soft decisions of each codeword of the parity check code to the input of the parity check code decoder 511 by a signal received from the decoder controller 519.

For each soft decision of each codeword of the parity check code, the parity check code decoder 511 forms a modified soft decision being an outgoing message of a codeword of the parity check code so that the outgoing message of the codeword of the parity check code is a product of functional transform of the source soft decisions. The parity check code decoder 511 decodes the parity check code, thus producing the outgoing messages of the codeword of the parity check code.

The first deinterleaver 513 deinterleaves the outgoing messages of the codeword of the parity check code so that each copy of the code symbol soft decision is assigned to an outgoing message of the codeword of the parity check code corresponding to the copy of the soft decision on this symbol.

The first switch 523 switches the soft decision about a code symbol stored in the memory 521 to the second deinterleaver 515. The first switch 523 switches soft decision about a code symbol by control signal of the decoder controller. The second deinterleaver 515 deinterleaves the soft decision about the code symbol stored in the memory so that each copy of the soft decision about the code symbol is assigned to an outgoing message of the codeword of the parity check code deinterleaved in the first deinterleaver 513 and corresponding to the copy of the soft decision about this symbol.

The first and second deinterleavers 513 and 515 provide the deinterleaved soft decisions to the repetition code decoder 517.

The repetition code decoder 517 organizes the outgoing messages of the code words of the parity check code and the received soft decisions about the code symbols into groups, each group including the soft decision about each code symbol and an outgoing message of the codeword of the parity check code corresponding to the copy of the soft decision on this symbol.

For each soft decision about each codeword of the parity check code, a modified soft decision is formed which is an outgoing message of the codeword of the repetition code being a product of functional transform of incoming messages of the codeword of the repetition code. An outgoing message of the codeword of the repetition code is an incoming message of the codeword of the parity check code and an outgoing message of the parity check code is an incoming message of the codeword of the repetition code. The outgoing and incoming message exchange processing is iteratively repeated, thus forming a sequence of modified soft decisions at each iteration. Decoded codewords are formed from the sequence of the modified soft decisions.

The repetition code decoder 517 creates codewords of the repetition code by decoding and assigns each codeword of the repetition code to the code symbol, with each outgoing message of the codeword of the parity check code being an incoming message of the codeword of the repetition code.

The second switch 527 outputs the outgoing message of the codeword of the repetition code to the interleaver 525 according to a control signal received from the decoder controller 519. The interleaver 525 interleaves the outgoing message of the codeword of the repetition code.

According to the control signal received from the decoder controller 519, the second switch 527 also switches the decoded codeword received from the repetition code decoder 517 to the calculator 425 illustrated in FIG 4.
The outgoing and incoming message exchange processing is iterated, thus forming a sequence of modified soft decisions at each iteration. An outgoing message of the codeword of the repetition code is an incoming message of the codeword of the parity check code and an outgoing message of the parity check code is an incoming message of the codeword of the repetition code. Decoded codewords are formed from the sequence of the modified soft decisions.

A description is now provided of an error detection algorithm for a codeword according to the present invention.

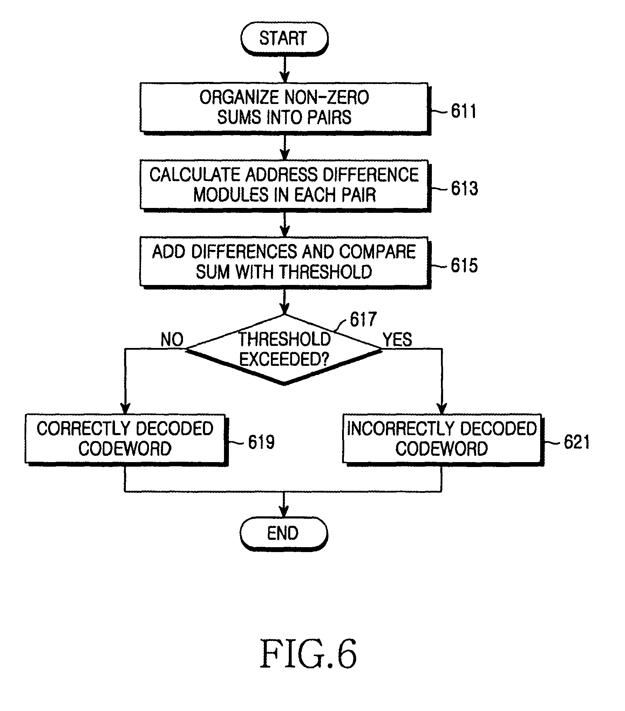

FIG 6 is a flowchart illustrating an error detection algorithm for a codeword according to an exemplary embodiment of the present invention. Referring to FIG 6, the receiver organizes non-zero sums into pairs of parity check sum sequence in step 611 and calculates address difference modules in each pair in step 613.

The receiver adds the differences in step 615 and compares the sum with the threshold in step 617. If the sum exceeds the threshold, the receiver determines that a current codeword has been decoded correctly in step 619. If the sum is equal to or less than the threshold, the receiver determines that the current codeword has been decoded incorrectly in step 621.

In the present invention, iterative decoding can be in a parallel mode. An exchange procedure between check and variable nodes is performed once per iteration and messages in each of the codewords of the repetition code or codewords of the parity check code are processed independently.

The iterative decoding can be performed in a successive mode. Messages are processed sequentially in the codewords of the repetition code and in the codewords of the parity check codes, and at least one outgoing message of the processed codeword of one code is an incoming message for the codeword of the other code.

The iterative decoding can be performed in a successive-parallel mode by extracting a sub-plurality of codewords processed in the parallel mode and a sub-plurality of codewords processed in the sequential mode in a plurality of codewords of the repetition code and the parity check code.

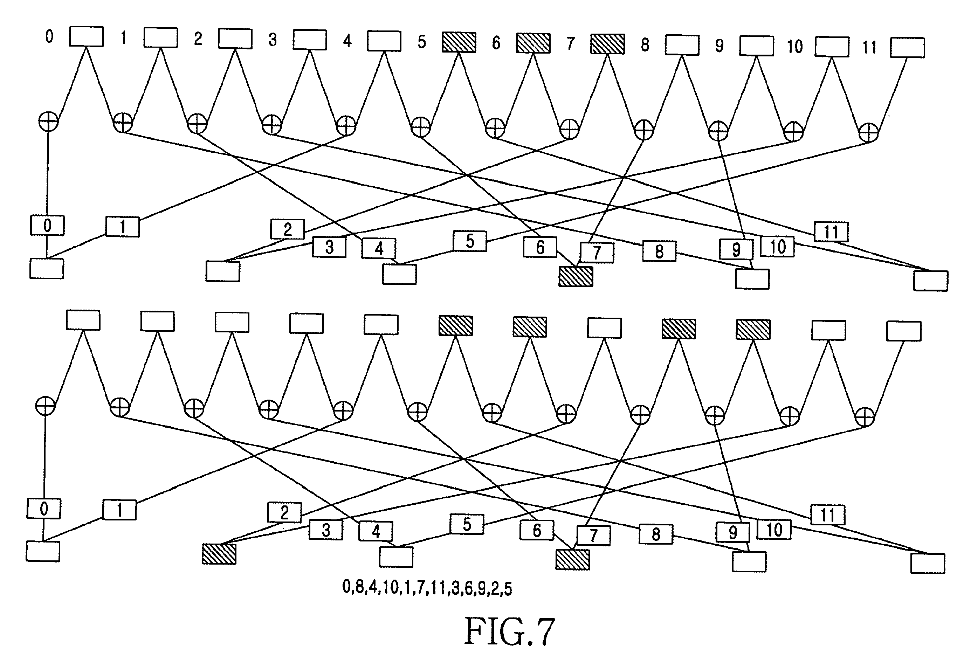

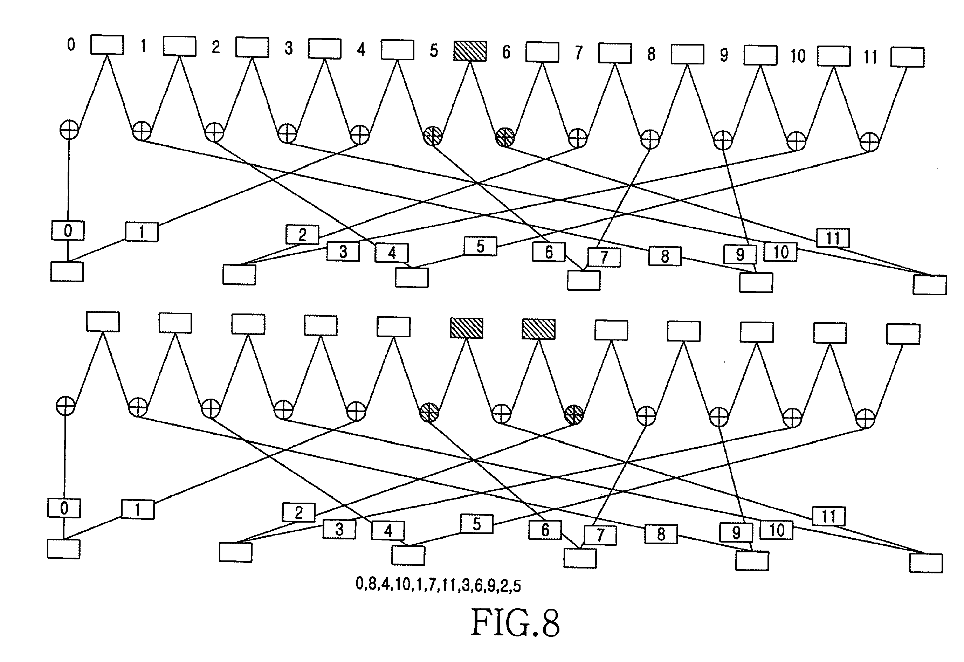

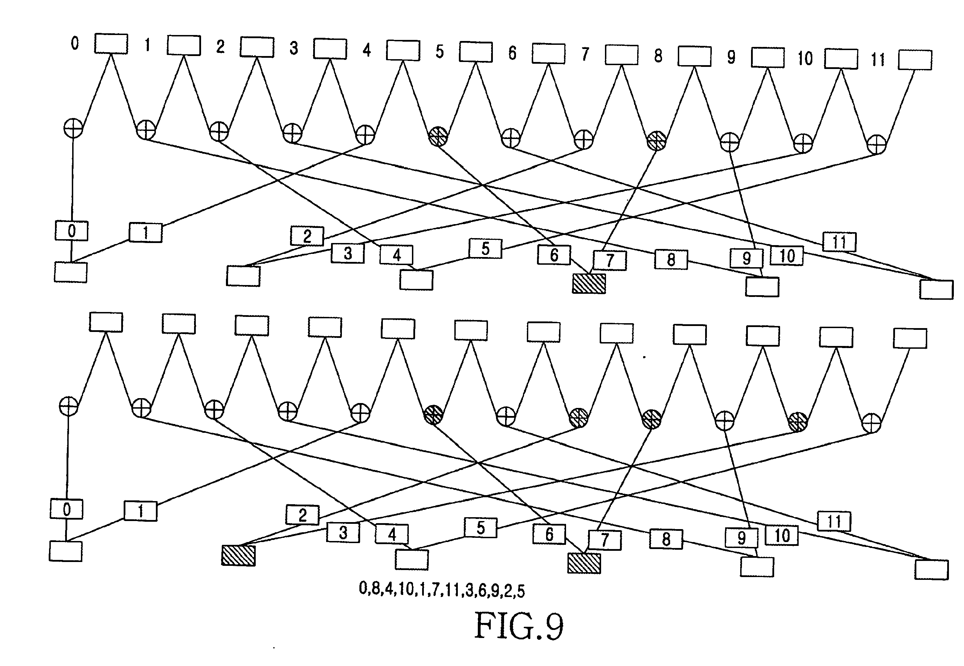

Error detection according to the present invention will be described below with reference to FIGs. 7, 8 and 9. FIG 7 illustrates undetected errors according to an exemplary embodiment of the present invention and FIG 8 illustrates a case where errors occur in the parity check part of a codeword according to an exemplary embodiment of the present invention. FIG 9 illustrates spreading of non-zero parity check sums with a distance proportional to an interleaver spread factor according to an exemplary embodiment of the present invention.

Referring to FIGs. 7, 8 and 9, a repeat accumulate code is set up by a bipartite graph. Errors are highlighted in dark color. An erroneous decoded symbol, its respective variable vertex, is marked with dark color. Dark color of the variable vertex corresponds to a non-zero parity check sum.

A case exists where there are erroneous decoded variable vertices and all parity check sums equal zero. That is a case of undetectable errors, as illustrated in FIG. 7.

In Fig. 8, a case is illustrated when errors occur in only the parity check part of a codeword is examined. Note that each error in the parity check part results in inequality to null of two adjacent sums. However, non-zero parity check sums will be spread by a distance proportional to the interleaver spread factor, as illustrated in FIG. 9. Therefore, at the presence of a single error, one can easily determine what symbol the error belongs to, either information or a parity check one.

For this purpose, the difference of the numbers of check vertices corresponding to non-zero parity check sums should be sufficiently considered. If the difference is 1, an error symbol can be simply related to the check symbols, and if it is larger than 1, an error symbol is an information one.

Where many errors occur, the following detection algorithm is used. If the number of non-zero parity check sums is odd, the check value of the last sum is added, thus obtaining the even number of the parity check sums. Parity check sums are sequentially organized in pairs and the sum of differences of the parity check node numbers is calculated.

The obtained value is compared with the threshold and if it is below the threshold, the errors pertain to the check symbols only.

Therefore, error detection is performed without any CRC, thus improving the communication quality by reducing the number of redundant transmitted code symbols and providing error detection and correction.

The components utilized to implement the above-described operation are known and can be implemented on a processor, for instance.

Code symbol sequence interleaving can be considered in two ways.

In accordance an exemplary embodiment of the present invention, a code symbol sequence is organized into a plurality of sub-sequences. In each subsequence, interleaving is performed using a pilot pseudorandom sequence set by constructing a Hamilton path on a regular 4-valent graph. A Hamilton path or Hamiltonian cycle means a closed cycle without repeated edges passing through all graph vertices only once.

The pilot pseudorandom sequence is set in the following way. Let the graph contain a Hamilton path, and graph vertex numbers correspond to the order of passing along the path. The pilot pseudorandom sequence is set if there is another Hamilton path passing the graph edges not covered by a first path.

When passing along a second Hamilton path, the sequence of numbers of the passed vertices set while moving along the first path is obtained. The sequence defines the pilot pseudorandom sequence. The present invention allows a search for the pseudorandom sequence significantly by considering the entire pilot pseudorandom sequence family formed in one graph and provides the pseudorandom sequences with new properties, which results in an increased communication quality.

According to another exemplary embodiment of the present invention, the data sequence is organized into two sub-sequences. A spreading parameter for one of them exceeds a threshold $\sqrt{\dfrac{N}{2}}$ where N is an interleaver length.

A spreading parameter for the other subsequence is set to be within the threshold $\sqrt{\dfrac{N}{2}}$ .

In accordance with the first exemplary embodiment of interleaving a code symbol sequence, the code symbol sequence to be interleaved is organized into sub-sequences of code symbols to be interleaved. The code symbols between and/or within the sub-sequences are exchanged, thus forming interleaved code symbol sub-sequences. A final interleaved subsequence is formed from the sub-sequences.

A sequence of N symbols to be interleaved is organized into equal sub-sequences of a specified size K and each subsequence is interleaved according to a specified sub-sequence interleaving rule.

To perform this interleaving operation, a 4-regular graph is formed, of which the chromatic number is no less than 4 and the girth of which is more than or equal to the chromatic number. An initial vertex of the graph is determined. A first path is found, which passes each of its vertices and which does not pass either of its edges twice, starting from the initial vertex. The passed vertices are numbered and the passed edges are marked. A second path is formed by passing through the unmarked edges and each vertex once and storing the vertex numbers in the order of passing them, starting from a marked vertex.

If some of the vertices are encountered twice in the second path before all the graph vertices have been covered, the first path is searched for again.

If the length of the stored vertex number sequence does not coincide with the subsequence length, insignificant symbols are added to the subsequence.

According to the stored vertex numbers, an interleaved subsequence is formed by taking elements from each subsequence. Insignificant symbols are removed from the interleaved subsequence, if they have been added to it.

The interleaved sub-sequences are combined into a first interleaved sequence. In the first interleaved sequence, a second interleaving is carried out as follows.

For each symbol of the first interleaved sequence, a new number is formed by performing a transformation of the $i_{new} = (p \times i_{old} + s) mod\ N$ type, where $N$ is the number of interleaved elements, $i_{old}$ is an old number in the first interleaved sequence, and p is the co-prime with N.

A second interleaved sequence is generated by arranging the elements of the first interleaved sequence according to their new numbers. For each $K^{th}$ element starting from the first element, a new number is obtained in the second interleaved sequence, to be equal to $i_{new} = (i_{old} - K + N) mod N$. The numbers of the remaining elements of the sequence remain unchanged.

A final interleaved sequence is formed by arranging the elements according to their new numbers.

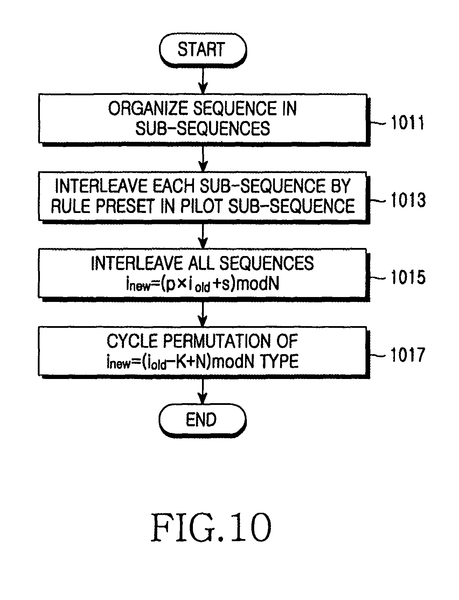

To implement the second exemplary embodiment of the interleaving method, a microprocessor operating as illustrated in FIG. 10 may be used.

Referring to FIG. 10, the interleaver organizes a sequence of symbols to be interleaved into sub-sequences of symbols to be interleaved in step 1011 and interleaves each subsequence according to an interleaving rule set in a pilot subsequence in step 1013.

The interleaver interleaves all sequences by the transformation of the $i_{new} = (p \times i_{old} + s) mod\ N$ type in step 1015 and performs cyclic permutation of the $i_{new} = (i_{old} - K + N) mod\ N$ type in step 1017.

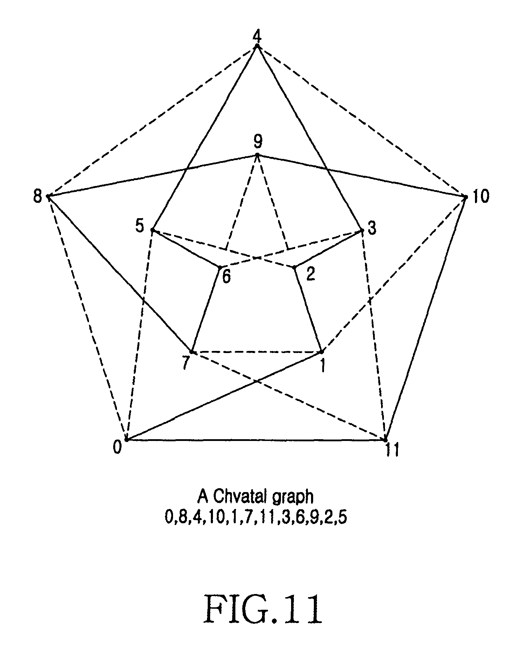

An interleaving graph according to the first interleaving method is illustrated in FIG. 11. The interleaving graph is, for example, a regular 4-valent Chvatal graph with numbered vertices. See, Bondy, J. A. and Murty, U. S. R. Graph Theory with Applications, New York, North Holland, p. 241, 1976.

FIG. 11 illustrates an interleaving graph (Chvatal graph) according to the first exemplary embodiment of the present invention. Referring to FIG. 11, the chromatic number of the Chvatal graph is 4. The vertices are numbered so that the difference between adjacent vertex numbers is 1. A Hamilton path in the graph is formed, which passes from the vertex with the minimum number to the vertex with the maximum number successively passing all the numbers.

A second Hamilton path is obtained, which moves along the edges not covered by the first path, considering that the vertex number sequence written in the order of passing them in the course of the second path forms a pilot pseudorandom sequence.

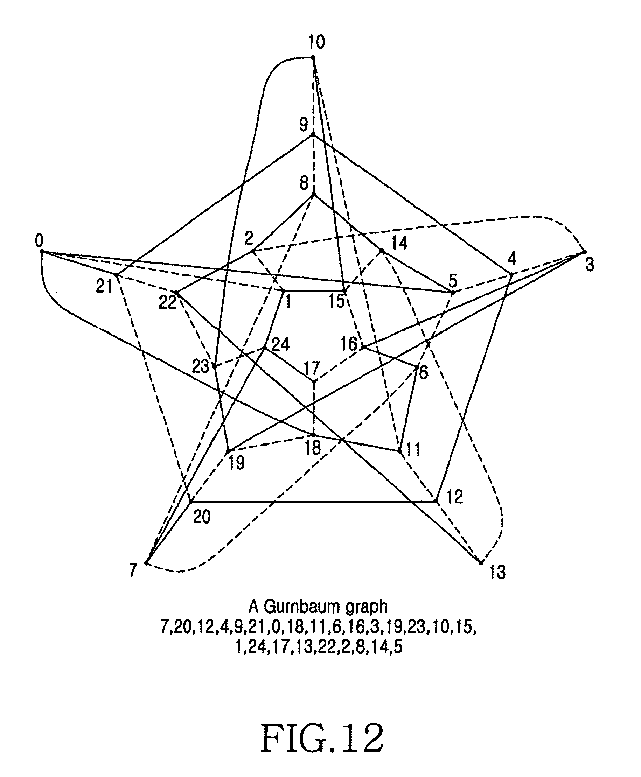

Another interleaving graph according to the first interleaving method is illustrated in FIG. 12. FIG. 12 illustrates an interleaving graph (Gumbaum graph) according to the first exemplary embodiment of the present invention.

Referring to FIG. 12, a pilot pseudorandom sequence can be obtained from the Gruenbaum graph which is, for example, a regular 4-valent Gruenbaum graph.

In accordance with the second exemplary embodiment of the interleaving method, a sequence of symbols to be interleaved is organized into sub-sequences of symbols to be interleaved. Interleaved code symbol sub-sequences are formed by exchanging the code symbols between and/or within the sub-sequences. A final interleaved subsequence is formed from the sub-sequences.

A sequence of N symbols to be interleaved is organized into two sub-sequences of symbols to be interleaved. One sub-sequence contains $N_1$ symbols to be interleaved and the other contains $(N-N_1)$ symbols to be interleaved.

The first and the second sub-sequences are formed so that the first subsequence meets the condition $|i-j| < S_1 + S_2 \Rightarrow |\Pi(i) - \Pi(j)| \geq S_1 + S_2$ and the second sub-sequence meets the condition $|i-j| < S_2 \Rightarrow |\Pi(i) - \Pi(j)| \geq S_2$, where i and j are code symbol numbers before the interleaving, $\Pi(i)$ and $\Pi(j)$ are code symbol numbers after the interleaving, $S_1$ and $S_2$ are positive integers, choosing $N_1$ symbols of the first sub-sequence based on first $N_1$ addresses, set in the pilot pseudorandom sequence and selecting $(N-N_1)$ symbols of the second sub-sequence based on last $(N-N_1)$ addresses, set in the pilot pseudorandom sequence.

To determine the pilot pseudorandom sequence, a set of numbers M from 0 to N-1 is formed, where N is the number of symbols to be interleaved. For this purpose, an initial value of a spreading parameter $S = S_1 + S_2$ is set, where $S_1$ and $S_2$ are positive integers, satisfying $S_1 + S_2 > \sqrt{\dfrac{N}{2}}$.

A plurality of number pairs $\Theta$ determining the law of biunique correspondence between the initial symbol sequence and the interleaved sequence is generated. The set includes one pair of numbers where a first number is an element number in the sequence before interleaving and a second number is an element number in the sequence after interleaving. The first number equals to zero and the second is equal to a number randomly selected from the plurality M, which is excluded from the plurality of numbers M. Then, i is initialized to 1, i.e. i=1.

An element $i_{\Pi}$ is randomly selected from the plurality M and the biunique correspondence between the element

$i_\Pi$ and the element $i$ is established, thus determining the transform $i_\Pi$ = n ($i$).

The distance spread of the interleaved symbols is checked. To do so, for all $j<i$ and $|i-j|<S$, $|\Pi(j)- n(i)|$ is calculated.

If all the obtained values are greater than or equal to S, i is increased by 1 (i=i+1), the element $i_\Pi$ is excluded from the plurality of numbers M, and the pair $i,i_\Pi$ is added to the plurality $\Theta$.

If at least one difference is smaller than S, another element i' from the plurality of numbers M is selected and the distance spread of the interleaved symbols is checked again for it.

If it is impossible to find an element satisfying the check of the interleaved symbols distance spread, the algorithm is repeated with the changed spread parameter S.

Once i reaches $N_1$ (i=$N_1$), the value $S_2$ is assigned to S.

The procedure is repeated until the plurality of numbers M is empty and the plurality $\Theta$ contains N pairs of numbers.

The final interleaved sequence is generated from the sub-sequences.

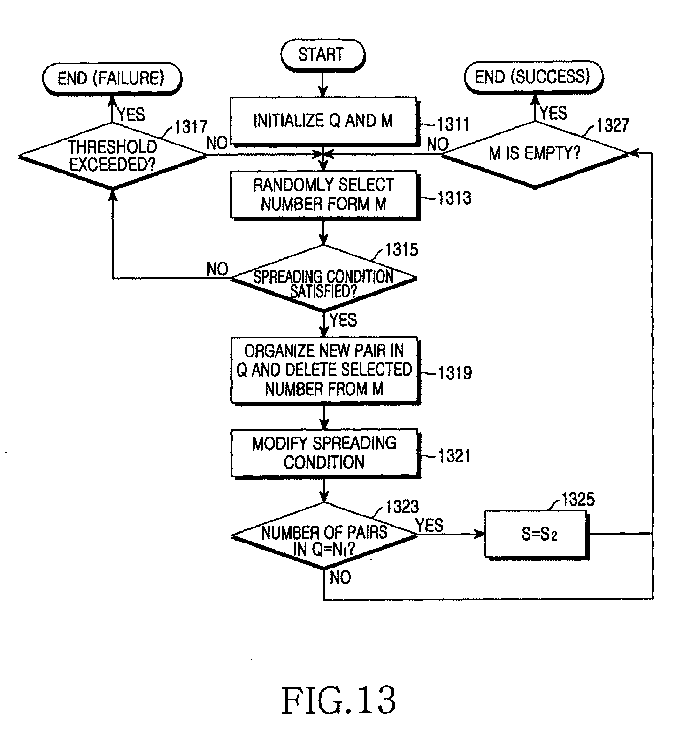

To implement the second exemplary embodiment of the interleaving method, a microprocessor operating as illustrated in FIG. 13 may be used.

FIG. 13 is a flowchart illustrating the interleaving method according to the second exemplary embodiment of the present invention.

Referring to FIG. 13, the interleaver initializes Q and M in step 1311. The interleaver randomly selects a number from M in step 1313 and determiens whether the spreading condition is satisifed in step 1315.

If the spreading condition is satisfied, the interleaver goes to step 1319 and otherwise, the interleaver goes to step 1317.

In step 1317, the interleaver compares the number of attempts with a predetermined threshold, If the number of attempts exceeds the threshold, the algorithm ends as failed.

If the number of attempts does not exceed the threshold, the interleaver goes to step 1313.

In step 1319, the interleaver organizes a new pair in Q and deletes the selected number from M. The interleaver compares the number of pairs in Q with $N_1$ in step 1323. If the number of pairs in Q is equal to $N_1$, the interleaver assigns $S_2$ as S in step 1325.

In step 1327, the interleaver determines whether M is empty. If M is empty, the algorithm ends as successful. If M is not empty, the interleaver returns to step 1313.

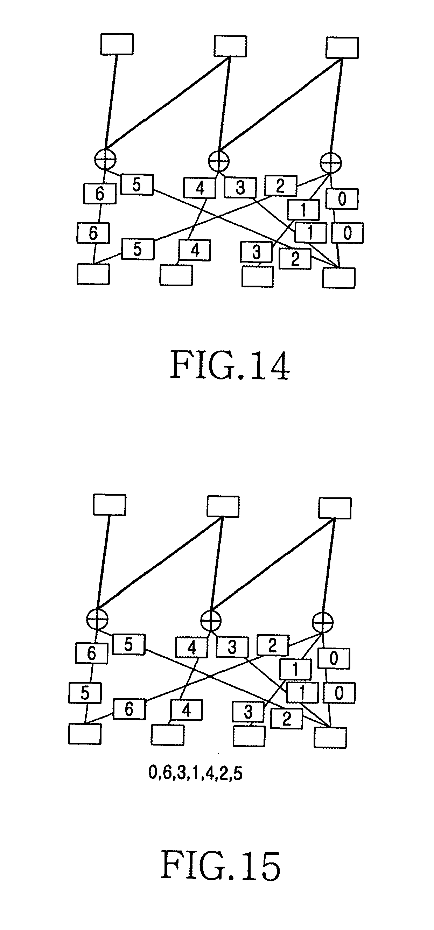

An interleaving graph according to the second interleaving method is illustrated in FIG. 14. The interleaving graph is a bipartite graph corresponding to a Hamming code (7, 4) where the connections between check vertices and variable vertices corresponding to the check symbols are highlighted in dark color. For details regarding background of the underlying codes, see Error detecting and correction codes, R.W. Hamming, Bell System Technical Journal, 1950, Vol. 29., pp. 147-160.

FIG. 14 illustrates an interleaving graph according to the second exemplary embodiment of the present invention. Referring to FIG. 14, as noted, the code constructed on the graph is a repeat accumulative code. According to an optimal repeat pattern, a first symbol is repeated three times, a second symbol is repeated once, a third symbol is repeated once, and a fourth symbol is repeated twice.

For convenience and conciseness of description, each end of each edge connecting check vertices to systematic variable vertices is numbered, thus establishing a biunique correspondence between them. Therefore, a pseudorandom interleaver should be made considering that two vertices cannot be connected by two edges at the same time. In other words, the first three elements of the interleaver should not be connected to one check vertex. This is fully guaranteed if the interleaver distance spread is no less than three, which meets the spread condition.

To achieve this goal, algorithm parameters are selected. Taking into account that a maximum repetition degree is 3, the algorithm parameters can be selected such that $N_1$=3, N=7, $S_1$=2, and $S_2$=1.

Thus, the symbol spreading condition of the interleaver is $|i-j|<3 \Rightarrow |\Pi(i)-\Pi(j)|\geq 3$. A zero element also becomes a zero element after the interleaving. Then the plurality of number pairs $\Theta$ and the number plurality M can be represented as Table 1 below.

Table 1

| $\Theta$ | | M |
|---|---|---|
| i | $i_\Pi$ | |
| 0 | 0 | empty |
| 1 | empty | 1 |
| 2 | empty | 2 |
| 3 | empty | 3 |

(continued)

| Θ | | M |
|---|---|---|
| 4 | empty | 4 |
| 5 | empty | 5 |
| 6 | empty | 6 |

If $i_{\Pi}$ =2, Table 1 will appear as Table 2.

Table 2

| Θ | | M |
|---|---|---|
| i | $i_{\Pi}$ | |
| 0 | 0 | empty |
| 1 | 2 | 1 |
| 2 | empty | empty |
| 3 | empty | 3 |
| 4 | empty | 4 |
| 5 | empty | 5 |
| 6 | empty | 6 |

Next, the spreading condition is checked with the following parameters, i=1, j=0, Π(*i*)=2, and Π(*j*)=0. If the spreading condition is not met, the next variant $i_{\Pi}$=3 is tried. In this case, the table will appear as Table 3 below.

Table 3

| Θ | | M |
|---|---|---|
| i | $i_{\Pi}$ | |
| 0 | 0 | empty |
| 1 | 3 | 1 |
| 2 | empty | 2 |
| 3 | empty | empty |
| 4 | empty | 4 |
| 5 | empty | 5 |
| 6 | empty | 6 |

It is obvious that the spreading condition is met in this case.

When the value i achieves $N_1$=3, two possible variables provided in the tables in the order of sequence will be left. From the following Table 4 or Table 5, it can be seen that these variables differ only in the order of the numbers taken.

Table 4

| Θ | | M |
|---|---|---|
| i | $^i\Pi$ | |
| 0 | 0 | Empty |
| 1 | 3 | 1 |
| 2 | 6 | 2 |
| 3 | empty | Empty |

(continued)

| Θ | | M |
|---|---|---|
| 4 | empty | 4 |
| 5 | empty | 5 |
| 6 | empty | Empty |

Table 5

| Θ | | M |
|---|---|---|
| i | $i_\Pi$ | |
| 0 | 0 | empty |
| 1 | 3 | 1 |
| 2 | 6 | 2 |
| 3 | empty | empty |
| 4 | empty | 4 |
| 5 | empty | 5 |
| 6 | empty | empty |

At the next step, a modified condition $|i\text{-}j|<2\Rightarrow|\Pi(i)\text{-}\Pi(j)|\geq2$ is used instead of the spreading condition of the interleaver because there are no numbers meeting the previous condition left. When i=1 during the next step, the following table is acquired.

Table 6

| Θ | | M |
|---|---|---|
| i | $i_\Pi$ | |
| 0 | 0 | empty |
| 1 | 3 | empty |
| 2 | 6 | 2 |
| 3 | 1 | empty |
| 4 | empty | 4 |
| 5 | empty | 5 |
| 6 | empty | empty |

Then, the following sets of parameters should be checked:

    1. i=3, j=2 $\Pi(i)$=1, $\Pi(j)$=3
    2. i=3, j=1 $\Pi(i)$=1, $\Pi(j)$=6

It can be seen that the algorithm may be completed by only one of the four number sequences.
FIG. 15 illustrates an interleaving graph according to the second exemplary embodiment of the present invention. Referring to FIG. 15, one of the four number sequences leads to a required perfect Hamming code, only with a different sequence of edge end numbers.

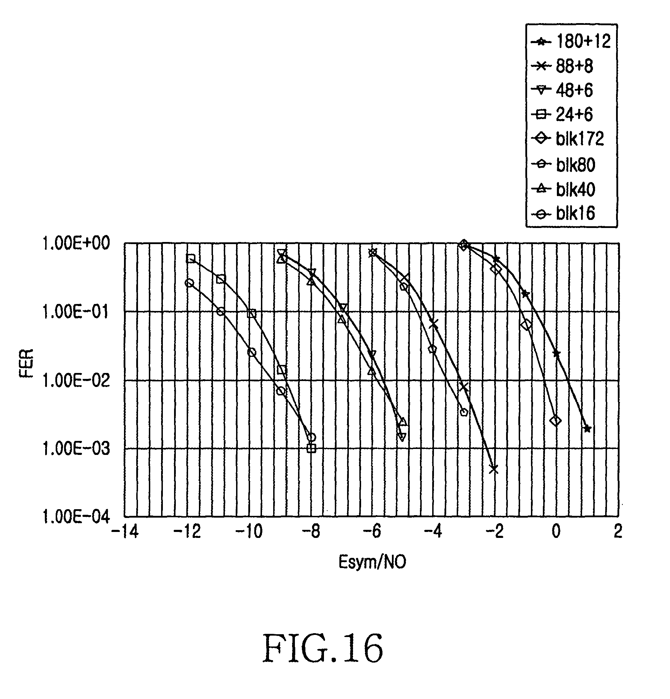

FIG. 16 is a graph illustrating performance when data is transmitted and received according to the exemplary embodiment of the present invention. Referring to FIG. 16, the results of a simulation on a multipath propagation channel of the 3rd Generation Partnership Project 2 (3GPP2) mobile communications standard are illustrated. Simulation conditions are a coding power gain of up to 1 dB at a coding rate $R = \dfrac{1}{4}$ and a 120 km/h mobile user speed. The channel model corresponds to a Case A-D described in <u>Spatial Channel Model AHG (Combined adhoc from 3GPP & 3GPP2),.</u> Version 6.0. Also, Frame Error Rate (FER) is shown with respect Signal-to-Noise Ratio (SNR).

The data block sizes used are the ones given in Header Removal (SO60) Header Compression (SO61) defined at Link-Layer Assisted Service Options for Voice-over-IP: Header Removal (SO60) and Robust Header Compression (SO61)//3GPP2 C.S0047-0, Version 1.0, April 14, 2003, Table 2.3-1 - 2.3-2, for application together with an EVRC vocoder disclosed in Speech Service Option 3 algorithm for Wideband, Spread Spectrum Digital Systems IS-127 defined by the TIA/EIA/IS-127 Recommendation.

The simulation reveals that the present method is more efficient than a Viterbi decoder with a CRC check sum for 16, 40, 80, and 172-bit voice data packets, corresponding to the 1.2, 2.4, 4.8, 9.6 kBit/sec data transmission rates used in the 3GPP2 standard.

The interleaving method according to the present invention is applicable to both interleavers in the transmitter and the receiver.

Compared to the conventional technology, the present invention includes the following distinctive features:

1. If the number of non-zero parity check sums is odd and the last parity check sum is non-zero, the latter is replaced with zero.

2. If the number of non-zero parity check sums is even and the last parity check sum of the sequence is zero, the latter is replaced with any nonzero value.

3. The sequence of parity check sums is organized into pairs, each including successive elements of the sequence, while each parity check sum is included in an individual pair.

4. A difference between the numbers of parity check sums is calculated in each pair.

5. All obtained differences between the numbers of the parity check sums are summed.

6. The obtained number is compared with the pre-set threshold. If this number exceeds the pre-set threshold, the information part of the codeword is considered to be incorrectly decoded.

7. If this number is less than the preset threshold, the information part of the codeword is considered to be correctly decoded.

As is apparent from the above description, the data transmitting/receiving apparatus and method in a communication system according to the present invention enable data transmission/reception using a coding scheme with a reduced complexity. Also, data transmission/reception can be performed using an optimized interleaving scheme and also using code symbol interleaving. The number of repeated transmission data can be reduced in the data transmission. Furthermore, simultaneous error detection and error correction is possible by improving an error detection algorithm through optimization of interleaving.

While the invention has been shown and described with reference to certain exemplary embodiments of the present invention thereof, it will be understood by those skilled in the art that various changes in form and details may be made therein without departing from the spirit and scope of the present invention as defined by the appended claims and their equivalents.

**Claims**

1.  A method for transmitting data in a communication system, the method comprising:

    repeating an information symbol;
    interleaving the repeated information symbols;
    organizing the interleaved repeated information symbols into groups of a predetermined size;
    calculating an $n^{th}$ parity check matrix by modulo summation of an $(n-1)^{th}$ parity check symbol and all interleaved repeated information symbols of an $n^{th}$ group; and
    generating a codeword by multiplying each of the information symbols by the parity check matrix and transmitting the codeword.

2.  The method of claim 1, wherein the calculation of an $n^{th}$ parity check matrix comprises calculating a first parity check matrix by multiplying a predetermined initial value by all interleaved repeated information symbols of a first group.

3.  The method of claim 2, wherein an $(n-1)^{th}$ parity check matrix is calculated using a previous input group and the $n^{th}$

parity check matrix is calculated using a current input group.

4. The method of claim 1, wherein the interleaving comprises interleaving each sub-sequence by constructing a Hamilton path on a regular graph.

5. The method of claim 4, wherein the interleaving comprises:

creating interleaved sub-sequences of code symbols by exchanging code symbols between and/or within sub-sequences;
creating a final interleaved sub-sequence from the sub-sequences;
organizing a sequence with N symbols to be interleaved into equal sub-sequences of a preset size of K; and
interleaving each of the sub-sequences according to a predetermined subsequence interleaving rule.

6. The method of claim 5, wherein the interleaving according to the interleaving rule comprises:

selecting an initial vertex on the graph;
searching for a first path passing through each vertex of the graph and passing any edge only once, starting from the selected vertex;
numbering the passed vertices and marking the passed edges;
forming a second path by moving along unmarked edges by passing each vertex once and storing numbers of vertices in order of passing, starting from the selected vertex;
searching for another first path, if any of the vertices are passed twice in the second path until all graph vertices have been passed;
adding insignificant symbols to the sub-sequence, if a length of the sequence of the stored vertex numbers does not comply with a length of the sub-sequence;
creating an interleaved sub-sequence by taking elements of each subsequence according to the stored numbers of the vertices;
removing insignificant symbols from the interleaved sub-sequence if the insignificant symbols have been added;
combining the interleaved sub-sequences into a first interleaved sequence;
performing a second interleaving on the first interleaved sequence by, for each symbol of the sequence, forming a first ordinal number in the sequence by performing a transformation of a $i_{new}=(p\times i_{old}+s) \bmod N$ type transform;
forming a second interleaved sequence by placing elements of first interleaved sequence according to new numbers;
getting a new number in the second interleaved sequence for each $K^{th}$ element from the first interleaved sequence, the new number being equal to $i_{new} = (i_{old} - K+N) \bmod N$, where N is a number of elements interleaved, $i_{old}$ is an old number in the first interleaved sequence, and p is a relative prime number with N, and numbers of other elements of the sequence remaining unchanged; and
forming a final interleaved sequence by placing elements according to the new numbers.

7. The method of claim 1, wherein the interleaving comprises performing spreading using spreading parameters, one of the spreading parameters exceeding $\sqrt{\dfrac{N}{2}}$ where N is an interleaver length and another spreading parameter being within the $\sqrt{\dfrac{N}{2}}$.

8. The method of claim 7, further comprising:

forming interleaved sub-sequences of code symbols by exchanging code symbols between and/or within sub-sequences;
forming a final interleaved sub-sequence from the sub-sequences;
organizing a sequence of N symbols to be interleaved into two sub-sequences of symbols to be interleaved, one sub-sequence containing $N_1$ symbols to be interleaved and an other containing $(N-N_1)$ symbols to be interleaved, so that a first sub-sequence meets a condition $|i-j|<S_1+S_2 \Rightarrow |\Pi(i)-\Pi(j)| \geq S_1+S_2$ and a second sub-sequence meets a condition $|i-j|<S_2 \Rightarrow |\Pi(i)-\Pi(j)| \geq S_2$, where i and j are code symbol numbers before interleaving, $\Pi(i)$ and $\Pi(j)$ are code symbol numbers after the interleaving, and $S_1$ and $S_2$ are positive integers;

forming a plurality of numbers M from 0 to N-1 where N is number of symbols prior to interleaving, to determine a pilot pseudorandom sequence;

forming a plurality of pairs of numbers $\Theta$ determining law of biunique correspondence between an initial symbol sequence and the interleaved symbol sequence;

initializing i=1;

randomly selecting an element $i_\Pi$ from a plurality M and assigning element $i_\Pi$ to element i, thus determining a transformation $i_\Pi = \Pi(i)$;

checking a distance spread of interleaved symbols;

calculating $|\Pi(j)-\Pi(i)|$;

increasing i by 1 (i=i+1), excluding element $i_\Pi$ from the plurality M, and adding a pair $i,i_\Pi$ to plurality $\Theta$, if all obtained values are greater than or equal to S;

selecting another element i' from the plurality M and repeating a check of the distance spread of the interleaved symbols, if at least one difference is smaller than S;

repeating the whole algorithm with changed spread parameter S, if not possible to find an element satisfying the check of the distance spread of the interleaved symbols;

assigning the value $S_2$ to S, if i reaches $N_1$ (i=$N_1$);

repeating the procedure until the plurality M is empty and the plurality $\Theta$ contains N pairs of digits; and

forming a final interleaved sequence from the sub-sequences.

9. A method for receiving data in a communication system, the method comprising:

forming correlation responses for code symbols of a received codeword and estimating a noise factor of the received codeword;

soft-deciding the code symbols using the noise factor and dividing the soft decisions into soft decisions about information symbols and soft decisions about parity check symbols;

repeating the soft decisions about information symbols and the soft decisions about parity check symbols;

interleaving the repeated information symbol soft decisions;

grouping the interleaved information symbol soft decisions;

forming an $n^{th}$ parity check codeword by updating an $n^{th}$ group of the interleaved information symbol soft decisions with a second copy of the soft decision about an $(n-1)^{th}$ parity check symbol and a first copy of the soft decision about $n^{th}$ parity check symbol;

creating a decoded codeword by decoding the interleaved information symbol soft decisions;

generating an ordered sequence of parity check sums by multiplying the decoded codeword by a parity check matrix;

calculating a difference between numbers of the parity check sums in each pair and adding all calculated differences; and

comparing the sum of the differences with a predetermined threshold, determining that an information part of the codeword is decoded incorrectly, if the sum exceeds the threshold, and determining whether the information part of the codeword is decoded correctly if the sum is equal to or less than the threshold.

10. The method of claim 9, wherein the noise factor estimation comprises estimating the noise factor for a white Gaussian noise channel environment.

11. The method of claim 9, further comprising repeating the soft decisions about parity check symbols at least twice except a last parity check symbol.

12. The method of claim 9, wherein the grouping comprises grouping the interleaved information symbol soft decisions in accordance with groups of information symbols in a transmitter.

13. The method of claim 9, wherein the generation of the sequence of parity check sums comprises:

determining whether the codeword is decoded correctly, if all parity check sums are equal to zero;

replacing a last parity check sum with zero, if a number of non-zero parity check sums is odd and a last parity check sum is non-zero; and

replacing the last parity check sum with any non-zero value, if the number of non-zero parity check sums is even and the last parity check sum of the sequence equals zero.

14. The method of claim 9, wherein the decoding comprises:

receiving soft decisions about each codeword of the parity check code and decoding the parity check code, thus producing outgoing messages of the codeword of the parity check code;

deinterleaving the outgoing messages of the codeword of the parity check code;

deinterleaving soft decisions about the code symbols; and

organizing the outgoing messages of the codewords of the parity check code and the soft decisions about the code symbols into groups and decoding the codeword.

15. The method of claim 14, wherein the deinterleaving of the outgoing messages comprises deinterleaving the outgoing messages of the codeword of the parity check code so that each copy of the code symbol soft decision is assigned to an outgoing message of the codeword of the parity check code.

16. The method of claim 14, wherein the codeword is formed from a modified soft decision sequence generated by iterative exchanges between incoming and outgoing messages of the codeword of the parity check code and incoming and outgoing messages of a codeword of a repetition code.

17. An apparatus for transmitting data in a communication system, the apparatus comprising:

a repeater for repeating an information symbol;

an interleaver for interleaving the repeated information symbols;

an organizer for organizing the interleaved repeated information symbols into groups of a predetermined size;

an adder for calculating an $n^{th}$ parity check matrix by modulo summation of an $(n-1)^{th}$ parity check symbol and all interleaved repeated information symbols of an $n^{th}$ group; and

a multiplexer for generating a codeword by multiplying each of the information symbols by the parity check matrix and transmitting the codeword.

18. The apparatus of claim 17, wherein the adder calculates a first parity check matrix by multiplying a predetermined initial value by all interleaved repeated information symbols of a first group.

19. The apparatus of claim 18, wherein an $(n-1)^{th}$ parity check matrix is calculated using a previous input group and the $n^{th}$ parity check matrix is calculated using a current input group.

20. The apparatus of claim 17, wherein the interleaver interleaves each sub-sequence by constructing a Hamilton path on a regular graph.

21. The apparatus of claim 20, wherein the interleaver creates interleaved sub-sequences of code symbols by exchanging code symbols between and/or within sub-sequences, creates a final interleaved sub-sequence from the sub-sequences, organizes a sequence with N symbols to be interleaved into equal sub-sequences of a preset size of K, and interleaves each of the sub-sequences according to a predetermined sub-sequence interleaving rule.

22. The apparatus of claim 21, wherein according to the interleaving rule, the interleaver selects an initial vertex on the graph, searches for a first path passing through each vertex of the graph and passing any edge only once, starting from the selected vertex, numbers the passed vertices and marks the passed edges, forms a second path by moving along unmarked edges by passing each vertex once and storing numbers of vertices in order of passing, starting from the selected vertex, searches for another first path, if any of the vertices are passed twice in the second path until all graph vertices have been passed, adds insignificant symbols to the subsequence, if a length of the sequence of the stored vertex numbers does not comply with a length of the sub-sequence, creates an interleaved sub-sequence by taking elements of each sub-sequence according to the stored numbers of the vertices, removes insignificant symbols from the interleaved sub-sequence if the insignificant symbols have been added, combines the interleaved sub-sequences into a first interleaved sequence, performs a second interleaving on the first interleaved sequence by, for each symbol of the sequence, forming a first ordinal number in the sequence by performing a transformation of a $i_{new} = (p{\times}i_{old} + s)\,mod\ N$ transformation type, forms a second interleaved sequence by placing elements of a first interleaved sequence according to new numbers, gets a new number in the second interleaved sequence for each $K^{th}$ element from the first interleaved sequence, the new number being equal to $i_{new}=(i_{old}-K+N)\ mod\ N$, where N is a number of elements interleaved, $i_{old}$ is an old number in the first interleaved sequence, and p is a relative prime number with N, and numbers of other elements of the sequence remaining unchanged, and forms a final interleaved sequence by placing elements according to the new numbers.

23. The apparatus of claim 17, wherein the interleaver performs spreading using spreading parameters, one of the spreading parameters exceeding $\sqrt{\dfrac{N}{2}}$ where N is an interleaver length and an other spreading parameter being

within the $\sqrt{\dfrac{N}{2}}$ .

24. The apparatus of claim 23, wherein the interleaver forms interleaved sub-sequences of code symbols by exchanging code symbols between and/or within sub-sequences, forms a final interleaved sub-sequence from the sub-sequences, organizes a sequence of N symbols to be interleaved into two sub-sequences of symbols to be interleaved, one sub-sequence containing $N_1$ symbols to be interleaved and an other containing $(N-N_1)$ symbols to be interleaved, so that a first subsequence meets a condition $|i\text{-}j|<S_1+S_2 \Rightarrow |\Pi(i)\text{-}\Pi(j)| \geq S_1+S_2$ and a second subsequence meets a condition $|i\text{-}j| <S_2 \Rightarrow |\Pi(i)\text{-}\Pi(j)| \geq S_2$, where i and j are code symbol numbers before interleaving, $\Pi(i)$ and $\Pi(j)$ are code symbol numbers after the interleaving, and $S_1$ and $S_2$ are positive integers, forms a plurality of numbers M from 0 to N-1 where N is a number of symbols prior to interleaving, to determine a pilot pseudorandom sequence, forms a plurality of pairs of numbers $\Theta$ determining a law of biunique correspondence between an initial symbol sequence and the interleaved symbol sequence, initializes i=1, randomly selects an element $i_\Pi$ from a plurality M and assigning element $i_\Pi$ to element i, thus determining a transformation $i_\Pi, =\Pi(i)$ , checks a distance spread of interleaved symbols, calculates $|\Pi(j)\text{-}\Pi(i)|$, increases i by 1 (i=i+1), excluding element $i_\Pi$ from the plurality M and adds a pair $i,i_\Pi$ to plurality $\Theta$, if all obtained values are greater than or equal to S, selects another element i' from the plurality M and repeating a check of the distance spread of the interleaved symbols, if at least one difference is smaller than S, repeats the whole algorithm with changed spread parameter S, if not possible to find an element satisfying the check of the distance spread of the interleaved symbols, assigns the value $S_2$ to S, if i reaches $N_1$ (i=$N_1$), repeats the procedure until the plurality M is empty and the plurality $\Theta$ contains N pairs of digits, and forms a final interleaved sequence from the sub-sequences.

25. An apparatus for receiving data in a communication system, the apparatus comprising:

   a noise factor estimator for forming correlation responses for code symbols of a received codeword and estimating a noise factor of the received codeword;
   a divider for soft-deciding the code symbols using the noise factor and dividing the soft decisions into soft decisions about information symbols and soft decisions about parity check symbols;
   a first repeater for repeating the soft decisions about information symbols;
   a second repeater for repeating the soft decisions about parity check symbols;
   an interleaver for interleaving the repeated information symbol soft decisions;
   a former for grouping the interleaved information symbol soft decisions and forming an $n^{th}$ parity check codeword by updating an $n^{th}$ group of the interleaved information symbol soft decisions with a second copy of the soft decision about an $(n-1)^{th}$ parity check symbol and a first copy of the soft decision about $n^{th}$ parity check symbol;
   a decoder for creating a decoded codeword by decoding the interleaved information symbol soft decisions;
   a calculator for generating an ordered sequence of parity check sums by multiplying the decoded codeword by a parity check matrix, calculating a difference between numbers of the parity check sums in each pair, and adding all calculated differences; and
   a controller for comparing the sum of the differences with a predetermined threshold, determining that an information part of the codeword is decoded incorrectly, if the sum exceeds the threshold, and determining whether the information part of the codeword is decoded correctly if the sum is equal to or less than the threshold.

26. The apparatus of claim 25, wherein the noise factor estimator estimates the noise factor for a white Gaussian noise channel environment.

27. The apparatus of claim 25, wherein the first repeater repeats the soft decisions about parity check symbols at least twice except a last parity check symbol.

28. The apparatus of claim 25, wherein the former groups the interleaved information symbol soft decisions in accordance with groups of information symbols in a transmitter.

29. The apparatus of claim 25, wherein the calculator determines whether the codeword is decoded correctly, if all parity check sums are equal to zero, replaces a last parity check sum with zero, if a number of non-zero parity check sums is odd and a last parity check sum is non-zero, and replaces the last parity check sum with any non-zero value, if the number of non-zero parity check sums is even and the last parity check sum of the sequence equals zero.

30. The apparatus of claim 25, wherein the decoder comprises:

a parity check code decoder for receiving soft decisions about each codeword of the parity check code and decoding the parity check code, thus producing outgoing messages of the codeword of the parity check code;
a first deinterleaver for deinterleaving the outgoing messages of the codeword of the parity check code;
a second deinterleaver for deinterleaving soft decisions about the code symbols; and
a repetition code decoder for organizing the outgoing messages of the codewords of the parity check code and the soft decisions about the code symbols into groups and decoding the codeword.

31. The apparatus of claim 30, wherein the first deinterleaver deinterleaves the outgoing messages of the codeword of the parity check code so that each copy of the code symbol soft decision is assigned to an outgoing message of the codeword of the parity check code.

32. The apparatus of claim 30, wherein the codeword is formed from a modified soft decision sequence generated by iterative exchanges between incoming and outgoing messages of the codeword of the parity check code and incoming and outgoing messages of a codeword of a repetition code.

FIG.1

FIG.2

FIG.3

FIG.4

EP 1 838 000 A2

FIG.5

START

ORGANIZE NON-ZERO
SUMS INTO PAIRS — 611

CALCULATE ADDRESS DIFFERENCE
MODULES IN EACH PAIR — 613

ADD DIFFERENCES AND COMPARE
SUM WITH THRESHOLD — 615

THRESHOLD
EXCEEDED? — 617

NO

YES

CORRECTLY DECODED
CODEWORD — 619

INCORRECTLY DECODED
CODEWORD — 621

END

FIG.6

0,8,4,10,1,7,11,3,6,9,2,5

FIG.7

0,8,4,10,1,7,11,3,6,9,2,5

FIG.8

FIG.9

0,8,4,10,1,7,11,3,6,9,2,5

START

ORGANIZE SEQUENCE IN
SUB-SEQUENCES ── 1011

INTERLEAVE EACH SUB-SEQUENCE BY
RULE PRESET IN PILOT SUB-SEQUENCE ── 1013

INTERLEAVE ALL SEQUENCES
$i_{new}=(p \times i_{old}+s)modN$ ── 1015

CYCLE PERMUTATION OF
$i_{new}=(i_{old}-K+N)modN$ TYPE ── 1017

END

FIG.10

A Chvatal graph
0,8,4,10,1,7,11,3,6,9,2,5

# FIG.11

A Gurnbaum graph
7,20,12,4,9,21,0,18,11,6,16,3,19,23,10,15,
1,24,17,13,22,2,8,14,5

# FIG.12

FIG.13

FIG.14

0,6,3,1,4,2,5

FIG.15

FIG.16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4295218 A, Tanner
- US 6453442 B, Sadjadpour
- US 6857087 B, Crozier

**Non-patent literature cited in the description**

- **L. R. RABINER ; R. W. SCHAFER.** Digital Processing of Speech Signals. Prentice Hall, 1978
- Near Shannon Limit Error - Correcting Coding and Decoding. **C. BERROU ; A. GLAVIEX ; P. THITIMA-JSHINA.** IEEE International Communications Conference: Proc. 1993, 1064-1070
- **GALLAGER R.** Low Density Parity Check Codes. MIT Press, 1963
- **R.M. TANNER.** A Recursive Approach to Low Complexity Codes. *IEEE Transaction on Information Theory.,* 1981, vol. IT-27 (9), 533-547
- **P. J. CAMERON ; J. H. VAN LINT.** Graph Theory, Coding Theory & Block Designs. 1980
- **S.S. PIETROBON.** *International J. of Satellite Communication,* 1998, vol. 16, 23-46
- **W. K. LEUNG ; W. L. LEE ; A. WU ; L. PING.** Efficient Implementation Technique of LDPC Decoder. *Electron. Lett.,* September 2001, vol. 37 (20), 1231-1232
- **TOM RICHARDSON ; RUDIGER URBANKE.** *The Capacity of Low-Density Parity-Check Codes under Message-Passing Decoding,* 09 March 2001
- **DAVID MACKAY.** Good Error-Correcting Codes Based on Very Sparse Matrices. *IEEE Transaction on Information Theory,* March 1999, vol. 45
- **THOMAS J. RICHARDSON ; RÜDIGER L URBANKE.** *Efficient Encoding of Low-Density Parity Check Codes*
- **H. JIN ; A. KHANDEKAR ; R. J. MCELIECE.** Irregular Repeat-Accumulate Codes. *Proceedings of the Second International Symposium on Turbo Codes and Related Topics,* September 2000, 1-8
- **J. LI.** Low-Complexity, Capacity-Approaching Coding Schemes: Design, Analysis and Applications. Texas A&M University, 2002
- **DOLINAR ; D. DIVSALAR.** Weight Distribution for turbo Codes Using Random and Non-Random Permutation. *JPL Progress report 42-122,* 15 August 1995, 56-65
- **S. DOLINAR ; D. DIVSALAR.** Weight Distribution for Turbo Codes using Random and Non-Random Permutation. *JPL Progress Report 42-122,* 15 August 1995, 56-65
- **BONDY, J. A. ; MURTY, U. S. R.** Graph Theory with Applications. North Holland, 1976, 241
- **R.W. HAMMING.** *Bell System Technical Journal,* 1950, vol. 29, 147-160